# DEMANDE DE BREVET EUROPEEN

(11) **EP 1 480 266 A2**
(43) Date de publication de la demande: **24.11.2004**
(21) Numéro de dépôt: 04291219.6
(22) Date de dépôt: 12.05.2004
(51) Int. Cl.: H01L 21/764, H01L 21/762

(54) **Procédé de réalisation d'un circuit électronique intégré comprenant des composants superposés et circuit électronique intégré ainsi obtenu**

(30) Priorité: 20.05.2003 FR 0306030
(71) Demandeur: STMicroelectronics S.A., 92120 Montrouge (FR)
(72) Inventeur: Delpech, Philippe, 38240 Meylan (FR); Regnier, Christophe, 38660 St. Hilaire du Touvet (FR); Cremer, Sébastien, 38000 Grenoble (FR); Monfray, Stéphane, 38000 Grenoble (FR)
(74) Mandataire: Loisel, Bertrand

(57) **Abrégé**

Un procédé de réalisation d'un circuit électronique intégré comprend la réalisation d'un premier (3) et d'un second (8) composants superposés au dessus d'un substrat (100). Un volume de matériau temporaire est formé sur le substrat (100), à l'emplacement du second composant (8). Le premier composant (3) est ensuite réalisé au dessus du volume de matériau temporaire par rapport au substrat, puis le second composant (8) est réalisé en utilisant au moins une cheminée d'accès au matériau temporaire. Le premier composant (3) peut être un composant actif, et le second composant (8) peut être un composant passif.

## Description

La présente invention concerne un procédé de réalisation d'un circuit électronique intégré comprenant des composants électroniques superposés.

Les circuits électroniques intégrés comprennent en général des composants actifs, tels que des transistors, réalisés à la surface d'un substrat semiconducteur. Ils comprennent aussi des couches de matériaux isolants électriquement superposées au dessus de la surface du substrat, au sein desquelles sont disposées des pistes métalliques qui constituent des connexions électriques entre les éléments actifs.

Certains circuits actuellement réalisés comprennent en outre des composants passifs, tels que des résistances, des inductances ou des condensateurs, qui sont aussi disposés au sein des couches de matériaux isolants. Ces composants sont réalisés sous une forme intégrée au circuit : ils sont réalisés pendant l'élaboration des couches superposées de matériaux isolants, par des dépôts adaptés de matériaux spécifiques.

Or certains composants passifs, particulièrement des condensateurs de capacités élevées, représentent un encombrement important du fait de leurs grandes dimensions. L'agencement de ces composants au sein des couches de matériaux isolants est alors difficilement compatible avec la disposition des pistes de connexions électriques. A titre d'exemple, un condensateur peut avoir une longueur qui atteint plusieurs centaines de micromètres, en fonction de sa capacité. Cet encombrement nécessite une augmentation de la taille du substrat du circuit, afin de pouvoir disposer tous les composants et toutes les pistes de connexions nécessaires au sein des couches de matériaux isolants qui recouvrent le substrat. Il en résulte alors une augmentation du prix du circuit intégré, particulièrement pénalisante pour la diffusion de tels circuits à grande échelle.

Un but de la présente invention consiste à réduire les tailles de circuits intégrés qui incorporent des composants ayant de grandes dimensions.

L'invention concerne un procédé de réalisation d'un circuit électronique intégré, qui comprend les étapes suivantes :
a) formation d'un volume de matériau temporaire sur un substrat ;
b) formation d'un premier composant électronique au-dessus du volume de matériau temporaire, d'un côté du volume de matériau temporaire opposé au substrat ;
c) formation d'au moins une cheminée d'accès entre une surface d'accès du circuit et le volume de matériau temporaire ;
d) évacuation d'une partie au moins du matériau temporaire par la cheminée d'accès de façon à évider une portion au moins du volume de matériau temporaire ; et
e) formation d'un second composant électronique dans la portion évidée du volume de matériau temporaire par introduction d'au moins un matériau par la cheminée d'accès.

Ainsi, selon l'invention, l'agencement du second composant entre le substrat et le premier composant ne réduit pas le volume disponible au dessus du premier composant pour répartir des pistes de connexions électriques. Une augmentation de la taille du substrat du circuit n'est donc pas nécessaire pour combiner les agencements du second composant et des pistes dans le circuit intégré.

Le procédé de l'invention comprend donc l'utilisation d'un matériau temporaire disposé à l'emplacement du second composant, entre le substrat et le premier composant. Le premier composant est réalisé, puis le second composant électronique est formé en utilisant la cheminée d'accès au matériau temporaire.

Grâce à cet ordre chronologique de réalisation des premier puis second composants, le second composant n'est pas altéré par un traitement du circuit nécessaire pour la réalisation du premier composant, tout en étant situé entre le substrat et le premier composant.

Selon le mode de mise en oeuvre préféré du procédé de l'invention, l'étape b) comprend un collage moléculaire d'un matériau semiconducteur sensiblement monocristallin sur le circuit, d'un côté du volume de matériau temporaire opposé au substrat. Une partie au moins du premier composant peut alors être réalisée au sein du matériau sensiblement monocristallin.

En outre, le procédé peut comprendre, entre les étapes a) et b), une formation d'un volume de matériau isolant électrique disposé au-dessus du volume de matériau temporaire par rapport au substrat, de telle sorte que le volume de matériau isolant électrique est situé dans le circuit final entre ledit premier composant et ledit second composant. Le premier composant est ainsi isolé électriquement du substrat et du second composant.

Ledit premier composant peut comprendre un composant actif, et ledit second composant peut comprendre un composant passif. Conformément aux significations attribuées par l'Homme du métier aux terminologies de composant actif et de composant passif, un composant actif peut être, par exemple, un transistor, et un composant passif peut être, par exemple, une résistance, une inductance ou un condensateur.

L'invention concerne aussi un circuit électronique intégré comprenant un substrat, au moins un composant électronique actif et un composant électronique passif portés par le substrat, le circuit étant caractérisé en ce que le composant passif est disposé entre le substrat et le composant actif.

Selon un mode de réalisation préférée de l'invention, une partie au moins du composant actif est disposée dans un volume de matériau semiconducteur sensiblement monocristallin. Le composant actif peut alors présenter des caractéristiques de fonctionnement remarquables, telles que des caractéristiques de conduction électrique, par exemple, grâce à la structure cristalline du matériau dans lequel est réalisée ladite partie du composant actif.

Par ailleurs, le circuit peut aussi comprendre un volume de matériau isolant électrique disposé entre le composant actif et le composant passif. Un tel volume isolant procure les avantages bien connus des circuits intégrés de type SOI («Silicon On Insulator»), notamment en termes de réduction des courants de fuite.

D'autres particularités et avantages de la présente invention apparaîtront dans la description ci-après d'un mode de réalisation non limitatif, en référence aux dessins annexés, parmi lesquels :
- les figures 1 à 5 et 6a illustrent différentes étapes d'un procédé de réalisation d'une résistance selon l'invention ;
- la figure 6b illustre un condensateur réalisé selon l'invention.

Dans ces figures, pour raison de clarté, les dimensions des différentes parties de composants représentées ne sont pas en proportion avec leurs dimensions réelles. Ces figures sont des vues en coupe d'un substrat sensiblement plan, considérées dans un plan perpendiculaire à la surface du substrat. Le substrat est placé dans la partie inférieure de chaque figure, et D désigne une direction perpendiculaire à la surface du substrat, orientée vers le haut des figures. Dans la suite, les termes «sur», «sous», «inférieur» et «supérieur» sont utilisés en référence avec cette orientation. Par ailleurs, sur toutes les figures, des références identiques correspondent à des éléments identiques.

Dans ce qui suit, les étapes élémentaires de procédé de fabrication d'un circuit électronique intégré connues de l'Homme du métier ne sont pas décrites en détail..On s'attache seulement à décrire une succession d'étapes élémentaires qui permet de réaliser un circuit électronique intégré selon le procédé de l'invention.

En tant que premier exemple de réalisation de l'invention, décrit ci-après, ledit premier composant est un transistor MOSFET, qui constitue le composant actif, et ledit second composant est une résistance électrique, qui constitue le composant passif.

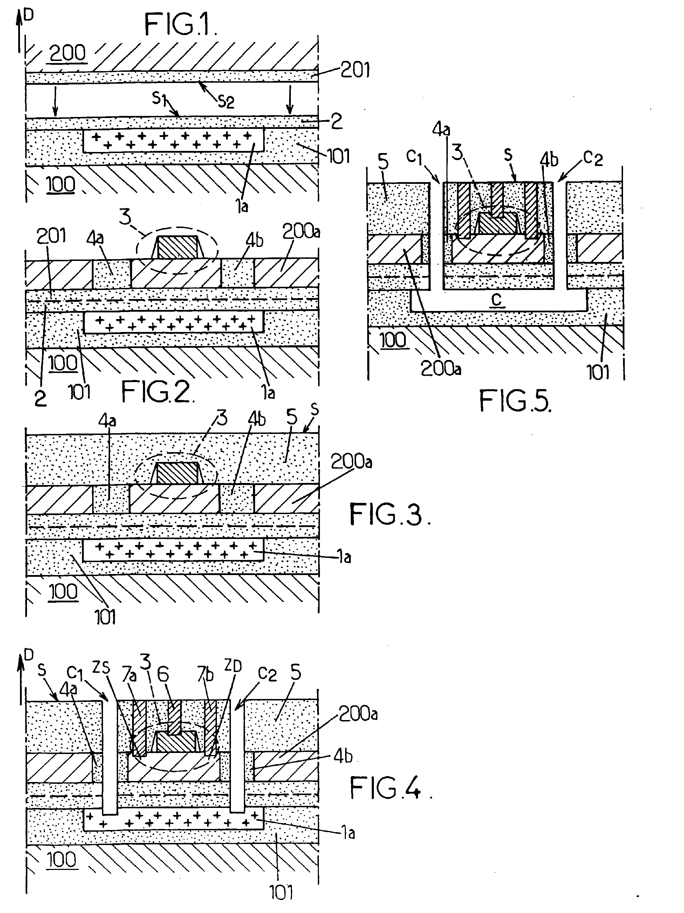

Selon la figure 1, un substrat 100, par exemple de silicium, est recouvert d'une couche de matériau isolant 101, par exemple de silice (SiO₂). L'épaisseur de la couche 101 est par exemple, de l'ordre de 200 nanomètres. En utilisant un masque lithographique, non représenté, on évide un volume 1 a par gravure de la couche 101. La profondeur du volume 1 a est, par exemple de 100 nanomètres selon la direction D. Le masque lithographique est ensuite retiré et le volume 1 a est rempli d'un matériau temporaire tel que, par exemple, du germanium ou un alliage de silicium et de germanium. Le matériau temporaire est choisi de façon à pouvoir être retiré ultérieurement de façon sélective par rapport à la couche 101. La surface supérieure du circuit est polie pour supprimer un éventuel excès de matériau temporaire au dessus de la surface supérieure de la couche 101. Une couche 2, de préférence de silice, est déposée sur le circuit. La surface supérieure S1 de la couche 2 est rigoureusement plane et dépourvue de tout élément étranger.

Un second substrat 200, de silicium monocristallin dopé, est aussi recouvert d'une couche de silice 201. La couche 201 peut être formée par oxydation thermique du silicium du substrat 200. La surface S2 de la couche 201 ainsi formée est aussi rigoureusement plane.

Selon le procédé connu de collage moléculaire (ou «wafer bonding», en anglais), les surfaces S1 et S2 sont amenées en contact l'une avec l'autre. Les substrats 100 et 200 sont alors chauffés au dessus de 800°C en étant pressés l'un contre l'autre. Des liaisons chimiques sont constituées entre les matériaux des couches 2 et 201, au niveau des surfaces de contact S1 et S2. Les substrats 100 et 200 sont ainsi solidarisés.

Une partie du substrat 200 est ensuite éliminée, de façon à ne laisser au dessus du substrat 100 qu'une pellicule 200a du substrat 200, d'épaisseur 50 nanomètres environ selon la direction D (figure 2). La partie éliminée du substrat 200 est retirée, par exemple, par polissage à partir d'une face du substrat 200 opposée au substrat 100. Le retrait est poursuivi par une gravure sèche «dry etching» en anglais), afin d'obtenir une surface supérieure de la pellicule 200a dépourvue de résidus de polissage. Grâce au procédé de collage moléculaire utilisé, la pellicule 200a est en silicium monocristallin de même qualité cristalline que le substrat initial 200.

On forme deux portions de gaines isolantes 4a et 4b dans la pellicule 200a. Les portions 4a et 4b peuvent, par exemple, être formées selon le procédé connu de formation des isolants par tranchées peu profondes (ou STI pour «Shallow Trench Insulator», en anglais).

On forme aussi un ou plusieurs transistors MOSFET 3 dans la pellicule 200a, au droit du volume 1a, avec des grilles respectives disposées au dessus de la pellicule 200a selon la technologie MOS connue. Pour raison de clarté, un seul transistor 3 est représenté sur les figures, mais un grand nombre, voire quelques milliers de transistors 3 peuvent être formés les uns à côté des autres dans la pellicule 200a au droit du volume 1a. Certains au moins des transistors 3 peuvent être situés entre les portions de gaines isolantes 4a et 4b, parallèlement à la surface supérieure de la pellicule 200a.

Des zones de la pellicule 200a sont alors implantées, de part et d'autre de chaque grille, afin de constituer les zones de source ZS et de drain ZD du transistor 3 correspondant, par dopage du silicium. Une activation du dopage est ensuite réalisée, qui peut consister, de façon connue, en un chauffage du circuit jusqu'à une température de 900°C environ.

On dépose sur le circuit une couche d'un matériau d'enrobage 5. La couche 5 peut être obtenue par dépôt chimique en phase vapeur (CVD pour «Chemical Vapour Deposition» en anglais) de silice, par exemple à partir du précurseur TEOS (pour tétraéthylorthosilicate). La surface supérieure S de la couche 5 est polie de façon à être plane et perpendiculaire à la direction D. La configuration du circuit obtenue est représentée sur la figure 3.

Par gravure sèche directionnelle («anisotropic dry etching», en anglais), selon la direction D et en sens opposé de celle-ci, on forme deux cheminées d'accès C1 et C2 et, pour chaque transistor 3, trois voies de contact 6, 7a et 7b (figure 4). Pour cela, un ou plusieurs plasmas de gravure successifs sont dirigés contre la surface S au travers d'ouvertures de masques lithographiques non représentés. Pour chaque transistor 3, la voie de contact 6 s'étend entre la surface S et la grille du transistor. Les voies de contact 7a et 7b s'étendent entre la surface S et, respectivement, la zone de source ZS et la zone de drain ZD du transistor. Les trois voies de contact 6, 7a et 7b sont ensuite remplies de matériau conducteur, tel que du nitrure de titane ou du tungstène, de façon à former respectivement une connexion électrique de grille, une connexion électrique de source et une connexion électrique de drain de chaque transistor 3.

Les ouvertures des masques lithographiques définissant les positions des sections supérieures des cheminées C1 et C2 dans le plan de la surface S sont situées de telle sorte que les cheminées C1 et C2 traversent les portions de gaines 4a et 4b, respectivement, sans être en contact avec la pellicule 200a.

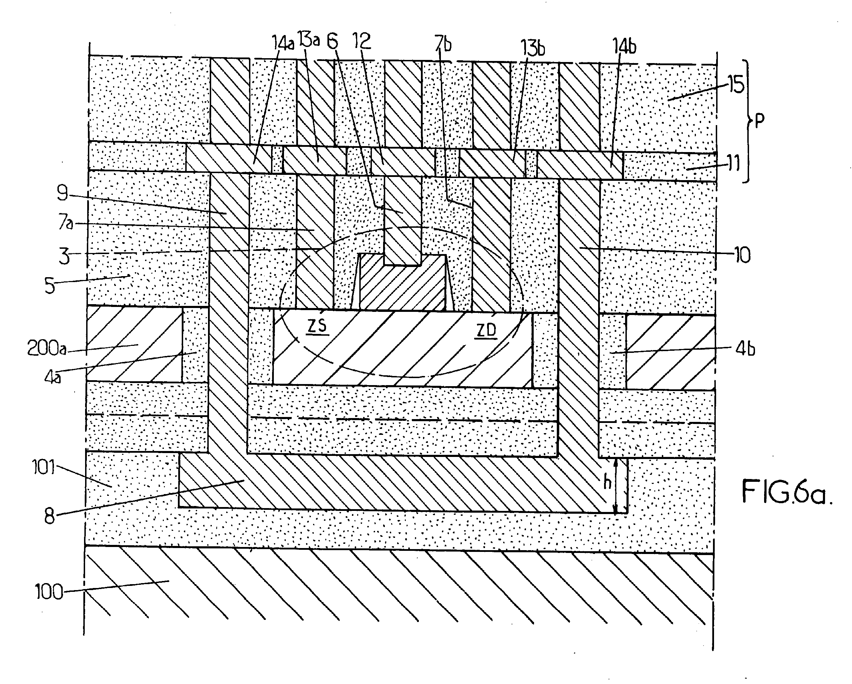

On introduit alors, par les cheminées C1 et C2, une solution liquide de gravure sélective du matériau temporaire du volume 1a. Si le matériau temporaire est du germanium ou un alliage de silicium et de germanium, une solution à la fois oxydante et acide peut être utilisée, qui ne dégrade pas la silice des couches 101, 2, 201 et 5, ni des portions 4a et 4b. On obtient une gravure isotrope du matériau temporaire du volume 1a, éliminé par dissolution dans la solution. Le volume 1a est ainsi évidé, de façon à former une cavité C (figure 5).

Alternativement, le matériau temporaire peut être éliminé par une gravure sèche isotrope, à l'aide d'un plasma pénétrant par les cheminées C1 et C2 jusqu'au volume 1a.

Afin de former dans le volume 1a une résistance, un matériau conducteur électrique est introduit dans la cavité C par les cheminées C1 et C2 (figure 6a). De façon préférée, le matériau conducteur est formé dans la cavité C par un dépôt chimique en phase vapeur, ou CVD («Chemical Vapour Deposition», en anglais). Pour cela, le substrat du circuit est chauffé. Un gaz contenant des précurseurs métalliques volatiles, du type organométallique ou du type chlorure par exemple, est alors amené au contact de la surface S. Les précurseurs pénètrent dans les cheminées C1 et C2, et se décomposent thermiquement au contact des parois de la cavité C en formant le matériau conducteur. La cavité C est ainsi remplie pour former le volume conducteur 8.

Le matériau conducteur peut être, par exemple, du nitrure de titane (TiN), du nitrure de tantale (TaN), du tungstène (W), du cobalt (Co) ou tout métal, composé ou alliage conducteur compatible avec le procédé de dépôt utilisé. La valeur de la résistance électrique peut être modifiée par le choix du matériau conducteur, ainsi que par une adaptation de la distance entre les cheminées C1 et C2.

Le matériau conducteur est simultanément déposé dans la cavité C et dans les cheminées d'accès C1, C2. La section de chaque cheminée C1, C2 est déterminée de façon à ce que chaque cheminée C1, C2 ne soit pas fermée avant que la cavité C soit entièrement remplie. Un remplissage complet de la cavité C n'est obtenu, pour une section donnée des cheminées C1 et C2, que si les deux cheminées ne sont pas trop éloignées l'une de l'autre. Si la cavité C possède une grande dimension parallèle à la surface du substrat, il peut être alors nécessaire de prévoir des cheminées d'accès supplémentaires, régulièrement disposées le long de cette dimension. Les inventeurs ont observé que, pour des cheminées d'accès ayant une section circulaire de diamètre de 150 nanomètres environ, deux cheminées voisines ne doivent pas être séparées d'une distance excédant 10 à 20 fois la hauteur h de la cavité C parallèlement à la direction D. Dans ces conditions, un remplissage complet de la cavité C est obtenu, ainsi que des cheminées C1 et C2. Le volume 8 rempli de matériau conducteur constitue la résistance, et les cheminées C1 et C2 constituent deux connexions électriques 9 et 10 qui relient chacune une extrémité de la résistance. Elles sont isolées électriquement des zones de source ZS et de drain ZD des transistors 3 par les portions de gaines 4a et 4b.

La surface supérieure du circuit est de nouveau polie, pour éliminer un dépôt de matériau conducteur formé sur celle-ci. La réalisation du circuit est alors poursuivie d'une façon connue en soi. En particulier, une portion supérieure de circuit P peut être disposée au dessus de la résistance. La portion P peut comprendre, notamment, des couches isolantes 11 et 15, au sein desquelles sont réalisés des volumes intermédiaires 12, 13a, 13b, 14a et 14b de matériau conducteur. Les volumes intermédiaires 12, 13a, 13b, 14a et 14b constituent des reprises de contacts électriques avec les connexions 6, 7a, 7b, 9 et 10, respectivement.

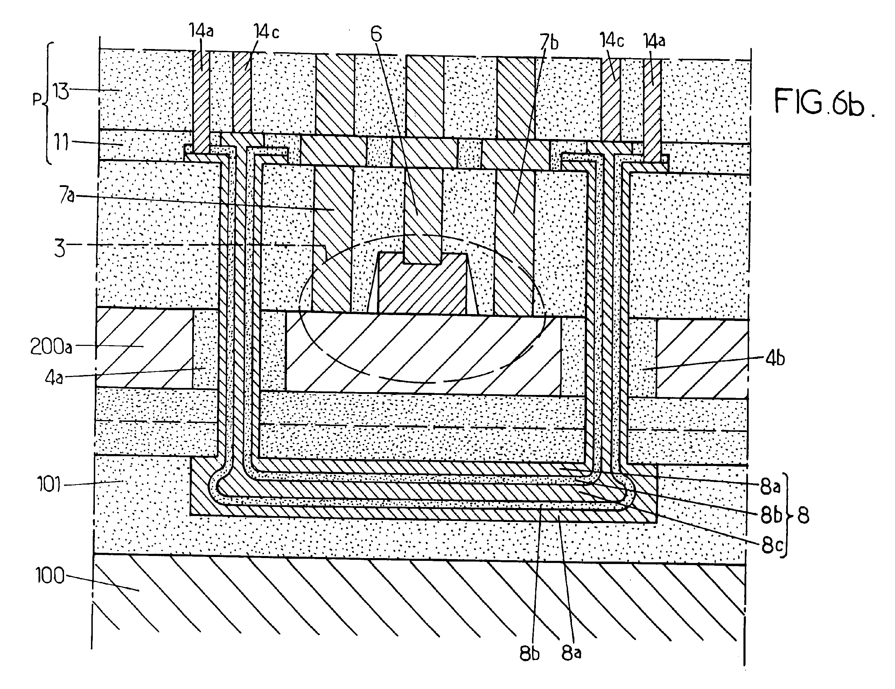

En tant que second exemple de réalisation de l'invention, la figure 6b illustre un condensateur obtenu à partir de la configuration du circuit correspondant à la figure 5. Un premier matériau conducteur électrique est introduit dans la cavité C par les cheminées C1 et C2. Le premier matériau conducteur est, par exemple, du nitrure de titane, du tungstène, de l'aluminium, du cuivre, tout composé conducteur, métal ou alliage métallique compatible avec le procédé utilisé. De même que dans le cas de la résistance ci-dessus, un procédé de dépôt par CVD peut être utilisé. Le premier matériau conducteur est ainsi déposé sur les parois internes de la cavité C et des cheminées C1 et C2 sous forme d'une couche continue 8a. Le dépôt est arrêté avant le remplissage complet de la cavité C et des cheminées C1 et C2. De façon analogue, une couche continue 8b de matériau diélectrique isolant est formée dans la cavité C et dans les cheminées C1 et C2, sur la couche 8a. Le matériau diélectrique de la couche 8b peut être, à titre d'exemple, de la silice (SiO₂), de l'alumine (Al₂O₃), de l'oxyde de titane (TiO₂), de l'oxyde de tantale (Ta₂O₅), de l'oxyde d'hafnium (HfO₂), ou tout autre oxyde ou nitrure. Enfin, une couche 8c d'un second matériau conducteur électrique, pouvant être identique au premier matériau conducteur électrique, mais non nécessairement, est formée dans la cavité C et dans les cheminées C1 et C2, sur la couche 8b. Les couches 8a, 8b et 8c forment un condensateur 8, dont la couche 8a constitue une armature externe, et la couche 8c constitue une armature interne, entourée par l'armature externe. La capacité du condensateur formé peut être modifiée par adaptation des dimensions du volume initial 1 a parallèlement à la surface du substrat 100.

Si la capacité recherchée du condensateur est faible, une seule cheminée d'accès à la cavité C peut être suffisante pour introduire les deux matériaux conducteurs dans la cavité C, ainsi que le matériau diélectrique, tout en obtenant des couches 8a, 8b et 8c qui recouvrent l'ensemble des parois internes de la cavité C.

La réalisation du circuit peut être poursuivie par l'élaboration d'une portion de circuit P, qui comprend des reprises de contacts électriques 14a et 14c adaptées à la configuration du condensateur 8.

Parmi les avantages de l'invention qui ressortent des exemples de réalisation décrits ci-dessus, on peut citer :
- la source, le canal et le drain du transistor 3 sont réalisés dans une pellicule de matériau monocristallin ;
- les couches de silice 2 et 201, qui adhérent l'une à l'autre lors du collage moléculaire, réalisent par ailleurs une isolation électrique entre le transistor 3 et la partie inférieure du circuit qui comprend le composant passif 8 et le substrat 100 ;
- les matériaux conducteurs du composant passif 8 qui, de façon générale, peuvent être altérés par un chauffage à une température supérieure à 500-600°C environ, ne sont pas soumis au chauffage d'activation des dopages des zones ZS et ZD du transistor 3 ;
- les connexions électriques formées dans les cheminées d'accès et qui relient le composant passif 8 à la portion de circuit P située d'un côté du composant actif 3 opposé au substrat 100 sont entourées, sur une portion de ces connexions, par des portions de gaines isolantes 4a et 4b. Ainsi ces connexions sont isolées électriquement de la pellicule de matériau monocristallin.

De nombreuses variantes peuvent être introduites dans le circuit et son procédé de réalisation décrits en détail ci-dessus. En particulier, la pellicule 200a transférée par collage moléculaire peut être remplacée par une couche de matériau semiconducteur obtenue par épitaxie à partir de portions découvertes de la surface du substrat 100.

Une autre variante consiste à former initialement le volume 1a par creusement dans le substrat 100 de silicium. Le substrat 100 peut alors être rendu isolant électriquement autour du volume 1a ainsi évidé de différentes manières. En particulier, une oxydation des parois du volume 1a évidé ou un recouvrement de ces parois par une couche d'un matériau isolant peuvent être effectués. Le matériau temporaire est ensuite déposé dans le volume 1a ainsi isolé du matériau de silicium du substrat 100. Le procédé est ensuite poursuivi de façon identique à celle décrite plus haut.

## Revendications

1. Procédé de réalisation d'un circuit intégré comprenant les étapes suivantes :
a) formation d'un volume de matériau temporaire (1a) sur un substrat (100) ;
b) formation d'un premier composant électronique (3) au-dessus du volume de matériau temporaire (1a), d'un côté du volume de matériau temporaire opposé au substrat ;
c) formation d'au moins une cheminée d'accès (C1, C2) entre une surface d'accès (S) du circuit et le volume de matériau temporaire (1a) ;
d) évacuation d'une partie au moins du matériau temporaire (1a) par la cheminée d'accès (C1, C2) de façon à évider une portion au moins du volume de matériau temporaire (C) ; et
e) formation d'un second composant électronique (8) dans la portion évidée du volume de matériau temporaire (C) par introduction d'au moins un matériau par la cheminée d'accès (C1, C2).

2. Procédé selon la revendication 1, comprenant en outre un chauffage du circuit réalisé avant l'étape e).

3. Procédé selon la revendication 1 ou 2, dans lequel l'étape b) comprend un collage moléculaire d'un matériau semiconducteur sensiblement monocristallin (200a) sur le circuit, d'un côté du volume de matériau temporaire (1a) opposé au substrat (100).

4. Procédé selon quelconque des revendications 1 à 3, comprenant en outre, entre les étapes a) et b), une formation d'un volume de matériau isolant électrique (2, 201) disposé au-dessus du volume de matériau temporaire (1a) par rapport au substrat (100), de telle sorte que le volume de matériau isolant électrique (2, 201) est situé dans le circuit final entre ledit premier composant (3) et ledit second composant (8).

5. Procédé selon l'une quelconque des revendications 1 à 4, comprenant en outre une formation d'une portion de gaine isolante (4a, 4b) autour d'une portion au moins de la cheminée d'accès (C1, C2).

6. Procédé selon l'une quelconque des revendications 1 à 5, dans lequel ledit second composant (8) comprend un composant passif.

7. Procédé selon l'une quelconque des revendications 1 à 6, dans lequel ledit premier composant (3) comprend un composant actif.

8. Circuit électronique intégré comprenant un substrat (100), au moins un composant électronique actif (3) et un composant électronique passif (8) portés par le substrat, **caractérisé en ce que** le composant passif est disposé entre le substrat et le composant actif.

9. Circuit selon la revendication 8, **caractérisé en ce qu'**une partie au moins du composant actif (3) est disposée dans un volume de matériau semiconducteur sensiblement monocristallin (200a).

10. Circuit selon la revendication 8 ou 9, comprenant en outre un volume de matériau isolant électrique (2, 201) disposé entre le composant actif (3) et le composant passif (8).

11. Circuit selon l'une quelconque des revendications 8 à 10, dans lequel au moins une connexion électrique (9, 10) reliant le composant passif (8) à une portion du circuit (P) située d'un côté du composant actif (3) opposé au substrat (100) est entourée, sur une portion de ladite connexion, par une portion de gaine isolante (4a, 4b).
